**Europäisches Patentamt**

**European Patent Office**

**Office européen des brevets**

(19)

(11) Veröffentlichungsnummer: **0 019 836**
**B1**

(12) **EUROPÄISCHE PATENTSCHRIFT**

(45) Veröffentlichungstag der Patentschrift:
12.01.83

(51) Int. Cl.³: **H 01 R 9/09**, H 05 K 3/36

(21) Anmeldenummer: **80102789.7**

(22) Anmeldetag: **20.05.80**

(54) **Einpolige mehrstufige Umschalteinrichtung für auf Printplatten gedruckte Schaltungen.**

(30) Priorität: **31.05.79 AT 3994/79**

(43) Veröffentlichungstag der Anmeldung:
**10.12.80 Patentblatt 80/25**

(45) Bekanntmachung des Hinweises auf die Patenterteilung:
**12.01.83 Patentblatt 83/2**

(84) Benannte Vertragsstaaten:
**BE CH DE LI NL**

(56) Entgegenhaltungen:
**DE-A-1 903 537**
**DE-A-2 749 543**
**DE-C-377 675**
**FR-A-809 290**
**FR-A-2 329 138**

**„IBM Technical Disclosure Bulletin", Bd. 10,
Nr. 6, November 1967, New York (US), A. CAS-
WELL et al.: „Bounceless multiple contact
switch". S. 699,700.**

(73) Patentinhaber: **SIEMENS AKTIENGESELLSCHAFT
Berlin und München, Postfach 22 02 61,
D-8000 München 22 (DE)**

(72) Erfinder: **Blebl, Hans, Dipl.-Ing., Postberg 13,
A-3011 Untertullnerbach (AT)**
Erfinder: **Stockinger, Helmut, Vorgartenstrasse 62-66,
A-1200 Wien (AT)**

## Einpolige mehrstufige Umschalteinrichtung für auf Printplatten gedruckte Schaltungen

Die Erfindung bezieht sich auf eine einpolige mehrstufige Umschalteinrichtung für auf Printplatten gedruckte Schaltungen zur Herstellung einer galvanischen Verbindung zwischen wählbaren Enden von geprinteten Leitern, vorzugsweise zwischen einem ersten Leiterende und einem aus einer Anzahl von äquidistant zu diesem angeordneten weiteren Leiterenden auswählbaren Leiterende mittels eines an die jeweils zu verbindenden Leiterenden andrückbaren Schaltstückes.

Bei auf Printplatten gedruckten Schaltungen kann es zweckmässig sein, zur stufenweisen Änderung von Parametern der Schaltung Umschalteinrichtungen zur stufenweisen Ein- und Ausschaltung von Teilen der Schaltung vorzusehen. Bisher wurden dafür vorgesehene Umschalteinrichtungen so ausgeführt, dass konzentrisch zu den kreisförmig verbreiterten Leiterenden buchsenförmige Elemente oder Träger von Innengewinden angeordnet und mit den Leiterenden unlösbar leitend verbunden wurden. Die Schaltverbindungen wurden entweder mittels mit Steckern oder steckerförmigen Elmenten versehenen Drahtleiterstücken durch Stöpseln oder mittels gelochten Schaltbügeln durch Verschrauben hergestellt. Diese Umschalteinrichtungen weisen den Nachteil auf, dass sie die Herstellung der Printplatten verkomplizieren, und dass sie durch ihre notwendigerweise von der Form der gedruckten Leiter abweichende Gestaltung sowie durch das unvermeidliche Heraustreten des Schaltstückes aus der Ebene der gedruckten Leiter, das einer Schleifenbildung gleichkommt, zwangsläufig Unstetigkeitsstellen des Wellenwiderstandes im Leitungsverlauf darstellen. Jeder Sprung im Wellenwiderstand eines Leitungszuges verursacht die Reflexion eines Teils des Leitungssignals. Die damit verbundene Verstärkungsminderung fällt besonders im Anwendungsbereich von ultrahohen Frequenzen sehr ins Gewicht. Die in diesem Frequenzbereich und insbesondere bei Breitband-Leistungsverstärkung verfügbaren Transistoren sind relativ teuer und weisen nur einen Gewinn von 5 bis 8 dB auf, so dass versucht werden muss, zusätzlichen Gewinn durch Ein- und Ausgangsanpassung zu erzielen. Daraus folgt, dass mit allen Mittels versucht werden muss, die teuer erkaufte Verstärkung nicht durch Reflexion zu verschenken.

Aufgabe der Erfindung ist es daher, eine Umschalteinrichtung anzugeben, bei der alle genannten, zu Reflexionen Anlass gebenden Faktoren ausgeschaltet sind.

Erfindungsgemäss wird diese Aufgabe dadurch gelöst, dass die Leiterenden kreisringförmig ausgebildet sind und im Mittelpunkt jedes Leiterendes eine Durchbohrung der Printplatte angebracht ist, dass das Schaltstück aus einem Isolierstoffplättchen und einem auf diesem aufgeprinteten geraden Leiterelement mit vorzugsweise gleichen Querschnittsabmessungen wie die Leiter der Printplatte besteht, dessen Enden kreisringförmig ausgebildet sind, wobei der Abstand zwischen deren Mittelpunkten dem einheitlichen Abstand der Mittelpunkte der zu verbindenden Leiterenden auf der Printplatte entspricht und im Mittelpunkt beider Enden des Leiterelementes Durchbohrungen des Isolierstoffplättchens angebracht sind, dass durch die Bohrungen des Isolierstoffplättchens hindurch Schrauben vorzugsweise mit selbst schneidendem Gewinde in die zugehörigen Bohrungen der Printplatte geschraubt sind, wobei die geprintete Seite des Schaltstückes den geprinteten Leitern der Printplatte zugewandt ist, und die Bohrungen in der Printplatte einen um ein zur kraftschlüssigen Aufnahme des Gewindes der Schrauben vorgeschriebenes Mass kleineren Durchmesser aufweisen als die Gewinde dieser Schrauben.

Der Vorteil der erfindungsgemässen Umschalteinrichtung liegt darin, dass sie den Leitungszug, in den sie eingefügt ist, in durchgeschaltetem Zustand homogen fortsetzt, da sowohl Leiterdimension als auch Leiterebene beim Schaltstück von den Werten der Printplatte nicht oder nur geringfügig abweichen und die Schrauben vom Prinzip her nicht als leitendes Element verwendet werden. Sprungstellen im Wellenwiderstand des Leitungszuges und dadurch verursachte Reflexionen treten somit nicht auf. Aber auch für Schaltungen, bei denen diese Kriterien nicht von grosser Bedeutung sind, wird durch die Erfindung eine zuverlässige und dabei billige und einfach anzuordnende Umschalteinrichtung angegeben, die keine zusätzlich in die Printplatte einzubauenden Kontaktelemente erfordert.

Ein Ausführungsbeispiel der Erfindung wird anhand der Zeichnung nachfolgend näher erläutert.

Fig. 1 zeigt eine schräge Unteransicht einer Printplatte mit der erfindungsgemässen Umschalteinrichtung,

Fig. 2 zeigt in Draufsicht eine mögliche Kontaktanordnung, und

Fig. 3 zeigt in Draufsicht eine mögliche Anwendungsform als nachträglich einzubauende Kontakteinrichtung.

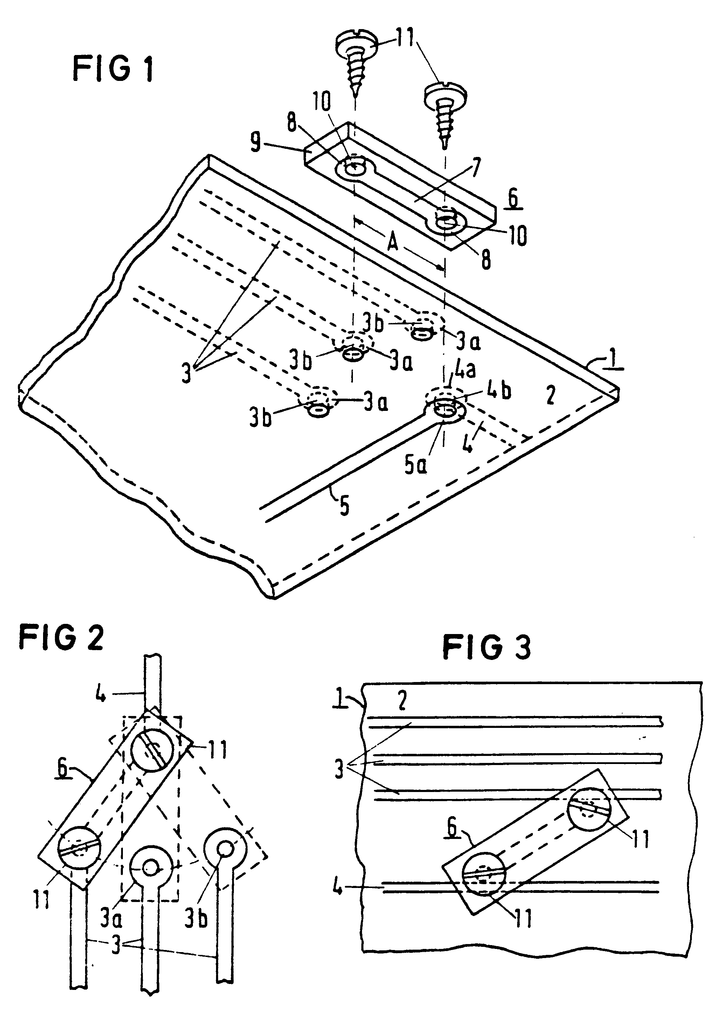

Fig. 1 zeigt im unteren Teil einen Abschnitt einer in bekannter Weise aus einer kupferkaschierten Isolierstoffplatte durch Wegätzen der nicht benötigten Kupferflächen hergestellten Printplatte 1, die aus der Isolierstoffplatte 2 und den auf ihr haftenden verbleibenden Leiterbahnen 3, 4, 5 besteht. Die einzelnen Leiterbahnen können ausschliesslich auf einer Seite der Isolierstoffplatte 2 verlaufen, z.B. 3, 4, sie können aber auch auf der anderen Seite der Isolierstoffplatte 2 weitergeführt sein, z.B. 5. Die gezeigten Leiterbahnen 3, 4, 5 enden in vorzugsweise kreisringförmigen Verbreiterungen 3a, 4a, 5a. Die galvanische Verbindung zwischen einer Leiterbahn 4 und einer diese auf der anderen Seite der Printplatte 2 fortsetzenden zugehörigen Leiterbahn 5 wird durch Durchkontaktierung zwischen deren kreisringförmig verbreiterten Leiterenden 4a, bzw. 5a hergestellt. Die leiterenden sind hier so angeordnet, dass sie als Kontakte für eine erfindungsgemässe Umschalteinrichtung dienen können. Dazu ist erstens der Abstand A zwischen allen Leiterenden 3a und dem als gemeinsamen Wurzelkontakt anzusehenden Leiterende 4a gleich gross vorgesehen, und zweitens sind in den Leiterenden 3a, 4a konzentrisch zu diesen angeordnete Durchbohrungen 3b, 4b der Isolierstoffplatte 2 vorgesehen.

Das eigentliche Schaltstück 6 wird im gleichen Verfahren und aus den gleichen Materialien wie die Printplatte 1 hergestellt und zeigt sich als ein gerades Leiterstück 7 mit vorzugsweise kreisingförmig verbreiterten Enden 8, das auf einem länglichen rechteckigen Plättchen 9 aus Isoliermaterial haftet. Der Abstand zwischen den Mittelpunkten der kreisringförmig verbreiterten Enden 8 ist genau gleich dem auf der Printplatte 1 vorgesehenen Abstand A zwischen allen Leiterenden 3a und dem Leiterende 4a. In den Leiterenden 8 sind konzentrisch zu diesen angeordnete Durchbohrungen 10 des Isolierstoffplättchens 9 vorgesehen. Der Durchmesser dieser Bohrungen 19 ist so gewählt, dass sie zur nahezu spielfreien Aufnahme der Schrauben 11 mit selbstschneidendem Gewinde geeignet sind.

Zur Herstellung einer Schaltverbindung zwischen zwei Leiterenden wird das Schaltstück 6 so auf die zu verbindende Strecke gelegt, dass die Leiterelemente von Printplatte 1 und Schaltstück 6 einander zugekehrt sind und die Achslagen aller korrespondierenden Bohrungen übereinstimmen. Dann werden die Schrauben 11 durch die Bohrungen 10 hindurch in die Bohrungen 3b, 4b eingeschraubt, deren Durchmesser nach Vorschrift oder nach eigenen Erfahrungen so auf die Abmessungen der verwendeten Schrauben 11 abzustimmen ist, dass in die Wandungen dieser Bohrungen selbsttätig die Gewindegänge eingeschnitten werden. Der Kontaktdruck ist dem zum Festziehen der Schraube 11 angewandten Schraubendrehermoment proportional und kann daher genau eingestellt und später jederzeit überprüft bzw. nachgestellt werden.

Die Fig. 2 verdeutlicht noch einmal in Draufsicht die Anordnung der Leiterelemente und der Bohrungen und zeigt die möglichen Stellungen des Schaltstückes 6 bei einer erfindungsgemässen Umschalteinrichtung mit einer Funktion als einpoliger Umschalter mit beispielsweise drei Schaltstellungen.

In Fig. 3 ist eine weitere Möglichkeit zur Anwendung der erfindungsgemässen Umschalteinrichtung angedeutet. Diese könnte hauptsächlich bei Versuchs- und Laborschaltungen von Interesse sein. Wie gezeigt wird, kann ein Schaltstück 6 nachträglich als Verbindungs- oder Kurzschlusselement in eine bestehende gedruckte Schaltung eingefügt werden, wobei alle dazu nötigen Manipulationen von einer Seite, der Leiterseite, aus durchführbar sind, und die Bohrungen so neben den Leitern 3, 4 angesetzt werden können, dass die Leiter nicht beschädigt werden. Durch die erfindungsgemässe kreisringförmige Ausgestaltung der Leiterenden 8 findet trotzdem eine zur sicheren Kontaktgabe ausreichende Berührung zwischen den Leiterenden 8 und den Leitern 3, 4 statt. Die Schatverbindung kann somit leicht nachträglich angebracht werden, sie kann beliebig oft geschlossen und geöffnet werden und nach ihrer endgültigen Beseitigung verbleiben nur zwei Bohrungen in der Isolierstoffplatte 2, die vollkommen ohne Einfluss auf die elektrischen Werte der Schaltung sind. In Abwandlung der in Fig. 3 gezeigten Möglichkeit kann die erfindungsgemässe Kontakteinrichtung auch als variabler Koppel- oder Ableitkondensator, vorwiegend wieder in Versuchsschaltungen verwendet werden. Das Schaltstück 6 wird dabei nur an einem seiner Enden mittels einer Schraube 11 in Kontakt mit einer Leiterbahn 3, 4 gebracht, und wird durch dosiertes Festziehen der Schraube 11 um diese als Drehpunkt unter sicherer Aufrechterhaltung des elektrischen Kontaktes verschwenkbar gemacht. Das andere Ende des Schaltstückes 6 kann dann durch Verschwenken mittels eines in dessen Bohrung 8 eingesetzten Dornes, vorteilhaft aus Isoliermaterial, einer zweiten Leiterbahn mehr oder weniger genähert werden und stellt somit einen Trimmerkondensator mit erwünscht grossem Variationsbereich eines kleinen Kapazitätswertes und Kapazitätsänderung durch Abstandveränderung dar. Durch endgültiges Festziehen der Befestigungsschraube 11 kann der letzlich eingestellte Kapazitätswert fixiert werden.

## Patentanspruch

Einpolige mehrstufige Umschalteinrichtung für auf Printplatten (1) gedruckte Schaltungen zur Herstellung einer galvanischen Verbindung zwischen wählbaren Enden von geprinteten Leitern (3), vorzugsweise zwischen einem ersten Leiterende (5a) und einem aus einer Anzahl von äquidistant zu diesem angeordneten weiteren Leiterenden (3a) auswählbaren Leiterende mittels eines an die jeweils zu verbindenden Leiterenden andrückbaren Schaltstücke (6), dadurch gekennzeichnet, dass die Leiterenden (3a, 4a, 5a) kreisringförmig ausgebildet sind und im Mittelpunkt jedes Leiterendes eine Durchbohrung (3b, 4b) der Printplatte (1) angebracht ist, dass das Schaltstück (6) aus einem Isolierstoffplättchen (9) und einem auf diesem aufgeprinteten geraden Leiterelement (7) mit vorzugsweise gleichen Querschnittsabmessungen wie die Leiter (3, 4, 5) der Printplatte (1) besteht, dessen Enden (8) kreisringförmig ausgebildet sind, wobei der Abstand zwischen deren Mittelpunkten dem einheitlichen Abstand der Mittelpunkte der zu verbindenden Leiterenden auf der Printplatte (1) entspricht und im Mittelpunkt beider Enden (8) des Leiterelementes (7) Durchbohrungen (10) des Isolierstoffplättchens (9) angebracht sind, dass durch die Bohrungen (10) des Isolierstoffplättchens (9) hindurch Schrauben (11) vorzugsweise mit selbstschneidendem Gewinde in die zugehörigen Bohrungen (3b, 4b) der Printplatte (1) geschraubt sind, wobei die geprintete Seite des Schaltstückes (6) den geprinteten Leitern (3, 4) der Printplatte (1) zugewendet ist und die Bohrungen (3b, 4b) in der Printplatte (1) einen um ein zur kraftschlüssigen Aufnahme des Gewindes der Schrauben (11) vorgeschriebenes Mass kleineren Durchmesser aufweisen als die Gewinde dieser Schrauben (11).

## Revendication

Dispositif de commutation unipolaire à plusieurs prises pour des circuits sur cartes imprimées (1), en vue de l'établissement d'une liaison galvanique — susceptible d'être choisie — entre des extrémités de conducteurs imprimés (3), de préférence entre une première extrémité de conducteur (5a) et une extrémité de conducteur parmi un grand nombre d'autres extrémités de conducteurs (3a), équidistante par rapport à celle-ci et susceptibles d'être sélectionnées, à l'aide d'une pièce de commutation (6) susceptible d'être pressée contre les extrémités des conducteurs à relier, caractérisé par le fait que les extrémités (3a, 4a, 5a) des conducteurs sont réalisées en forme d'anneau et par le fait que, au centre de chaque extrémité de conducteur, un perçage (3b, 4b) de la carte imprimée (1) est ménagé, que la pièce de commutation (6) est constituée par une plaquette (9) d'une matière isolante avec un élément conducteur droit (7) imprimé sur cette dernière, qui a de préférence les mêmes dimensions de sa section transversale que celles des conducteurs (3, 4, 5) de la carte imprimée (1) et dont les extrémités (8) sont réalisées en forme d'anneau, la distance entre leurs centres correspondant à la distance uniforme entre les centres des extrémités des conducteurs à relier sur la carte imprimée (1), et au centre des extrémités (8) de l'élément de conducteur (7) étant prévus des perçages (10) de la plaquette de matière isolante (9), qu'à travers les perçages (10) de la plaquette de matière isolante (9) sont vissées, dans les perçages associés (3b, 4b) de la carte imprimée (1), des vis (11) de préférence à filetage à autotaraudage, la face imprimée de la pièce de commutation (6) étant tournée du côté des conducteurs imprimés (3, 4) de la carte imprimée, et les perçages (3b, 4b) ménagés dans la carte imprimée (1) ayant un diamètre plus petit que le filetage des vis (11) — d'une valeur prescrite — pour recevoir le filetage de ces vis (11) avec un effet de transmission de forces.

## Claim

A single-pole, multi-stage switch-over errangement for circuits printed onto printing boards (1) for the production of a galvanic connection between selectable ends of printed conductors (3), especially between a first conductor end (5a) and a conductor end which can be selected from a number of further conductor ends (3a) which are arranged so as to be equidistant from the first conductor end, by means of a switching member (6) which can be pressed on to the respective conductor ends which are to be connected, characterized in that the conductor ends (3a, 4a, 5a) are annular and a bore (3b, 4b) in the printing board (1) is formed at the centre of each conductor end; that the switching member (6) consists of a platelet (9) of insulating material and a straight conductor element (7) which is printed thereon and preferably has the same cross-sectional dimensions as the conductors (3, 4, 5) of the printing board (1), the ends (8) of said conductor being annular, the distance between their centre points corresponding to the uniform distance of the centre points of the conductor ends on the printing board (1) which are to be connected, and bores (10) being formed in the platelet (9) of insulating material at the centre points of both ends (8) of the conductor element (7); and that screws (11), preferably having a self-tapping thread, are screwed through the bores (10) of the platelet (9) of insulating material into the assigned bores (3b, 4b) of the printing board (1), the printed side of the switching member (6) facing the printed conductors (3, 4) of the printing board (1) and the bores (3b, 4b) in the printing board (1) having a diameter which is smaller than that of the threads of these screws (11) by the amount which is prescribed for the force-locking accommodation of the threads of the screws (11).

FIG 1

FIG 2

FIG 3